# EUROPEAN PATENT SPECIFICATION

(11) **EP 3 155 655 B1**
(45) Date of publication and mention of the grant of the patent: **12.05.2021**
(21) Application number: 14895432.4
(22) Date of filing: 16.06.2014
(51) Int. Cl.: H01L 21/285, H01L 21/768, H01L 23/532

(54) **SELECTIVE DIFFUSION BARRIER BETWEEN METALS OF AN INTEGRATED CIRCUIT DEVICE**
SELEKTIVE DIFFUSIONSBARRIERE ZWISCHEN METALLEN EINER INTEGRIERTEN SCHALTVORRICHTUNG
BARRIÈRE DE DIFFUSION SÉLECTIVE ENTRE LES MÉTAUX D'UN DISPOSITIF À CIRCUIT INTÉGRÉ

(43) Date of publication of application: 19.04.2017
(73) Proprietor: Intel Corporation, Santa Clara, CA 95054 (US)
(72) Inventor: ROBERTS, Jeanette M., North Plains, Oregon 97133 (US); ROMERO, Patricio E., Portland, Oregon 97225 (US); CLENDENNING, Scott B., portland, OR 97225 (US); JEZEWSKI, Christopher J., Portland, Oregon 97229 (US); CHEBIAM , Ramanan V., Hillsboro, Oregon 97124 (US)
(74) Representative: Goddar, Heinz J.
(86) International application number: PCT/US2014/042568
(87) International publication number: WO 2015/195080

(56) References cited:
- JP-A- 2008 060 507
- JP-A- 2008 060 507
- KR-A- 20090 067 365
- KR-B1- 100 761 467
- US-A1- 2003 207 560
- US-A1- 2004 227 242
- US-A1- 2006 121 733
- US-A1- 2008 012 134
- US-A1- 2008 044 999
- US-A1- 2008 044 999
- US-A1- 2008 206 982
- US-A1- 2014 019 716

## Description

### Field

Embodiments of the present disclosure generally relate to the field of integrated circuits, and more particularly, to a selective diffusion barrier between metals of an integrated circuit (IC) device and associated techniques and configurations.

### Background

Emerging interconnect structures of integrated circuit (IC) devices may incorporate different metals to increase electrical performance. However, the different metals may be soluble in each other at temperatures typically used in connection with backend processing (e.g., up to about 400°C). Diffusion of the different metals may result in voids in the metals, which may adversely affect electrical performance or cause defects such as electrically open circuits, or diffusion of the metals into dielectric material, which may result in electrical leakage, dielectric breakdown, shorts or migration resulting in device failure US20080044999 and US20030207560 disclose prior art devices comprising a dielectric material with two electrically coupled interconnects with a diffusion barrier interposed.

### Brief Description of the Drawings

Embodiments will be readily understood by the following detailed description in conjunction with the accompanying drawings. To facilitate this description, like reference numerals designate like structural elements. Embodiments are illustrated by way of example and not by way of limitation in the figures of the accompanying drawings.
**FIG. 1** schematically illustrates a top view of an example die in wafer form and in singulated form, in accordance with some embodiments.
**FIG. 2** schematically illustrates a cross-section side view of an integrated circuit (IC) assembly, in accordance with some embodiments.
**FIGS. 3a****-b** schematically illustrate a cross-section side view of an interconnect assembly during various stages of fabrication, in accordance with some embodiments.
**FIG. 4** schematically illustrates a metal precursor for selective deposition of a diffusion barrier, in accordance with some embodiments.
**FIGS. 5a****-b** schematically illustrate a cross-section side view of another interconnect assembly during various stages of fabrication, in accordance with some embodiments.
**FIG. 6** schematically illustrates a flow diagram for a method of fabricating an interconnect assembly, in accordance with some embodiments.
**FIG. 7** schematically illustrates an example system that may include an interconnect assembly as described herein, in accordance with some embodiments.

### Detailed Description

Embodiments of the present disclosure describe a selective diffusion barrier between metals of an integrated circuit (IC) device and associated techniques and configurations. In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, side, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

As used herein, the term "module" may refer to, be part of, or include an Application Specific Integrated Circuit (ASIC), an electronic circuit, a processor (shared, dedicated, or group) and/or memory (shared, dedicated, or group) that execute one or more software or firmware programs, a combinational logic circuit, and/or other suitable components that provide the described functionality.

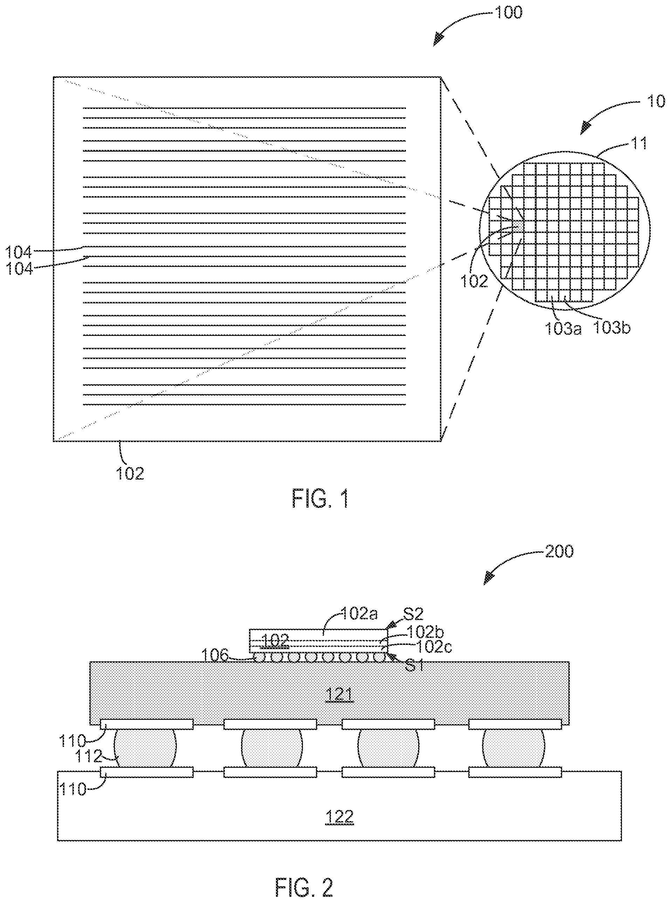

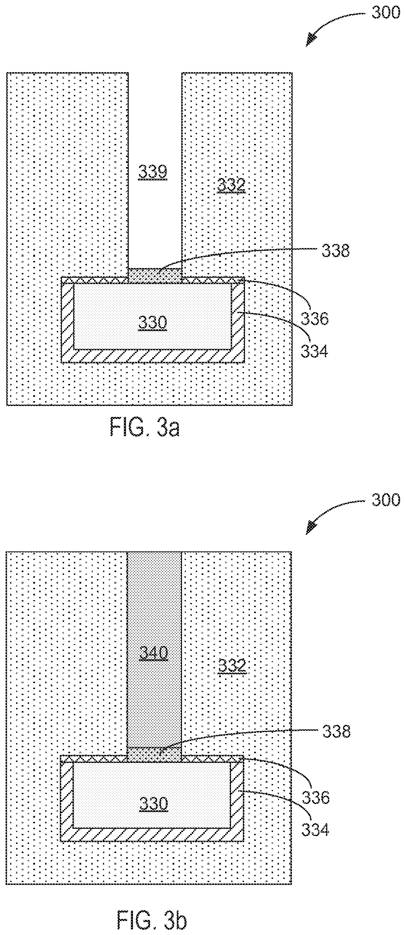

**FIG. 1** schematically illustrates a top view of an example die 102 in wafer form 10 and in singulated form 100, in accordance with some embodiments. In some embodiments, the die 102 may be one of a plurality of dies (e.g., dies 102, 103a, 103b) of a wafer 11 composed of semiconductor material such as, for example, silicon or other suitable material. The plurality of dies may be formed on a surface of the wafer 11. Each of the dies may be a repeating unit of a semiconductor product that includes an interconnect assembly (e.g., interconnect assembly 300 of FIGS. 3a-b) as described herein. For example, the die 102 may include circuitry having transistor elements such as, for example, one or more channel bodies (e.g., fin structures, nanowires, planar bodies, etc.) that provide a channel pathway for mobile charge carriers of one or more transistor devices. Interconnects 104 may be formed on and coupled with the one or more transistor devices. For example, the interconnects 104 may be electrically coupled with a channel body to provide a gate electrode for delivery of a threshold voltage and/or a source/drain current to provide mobile charge carriers for operation of a transistor device. Although the interconnects 104 are depicted in rows that traverse a substantial portion of the die 102 in FIG. 1 for the sake of simplicity, it is to be understood that the interconnects 104 may be configured in any of a wide variety of other suitable arrangements on the die 102 in other embodiments, including vertical and horizontal features having much smaller dimensions than depicted.

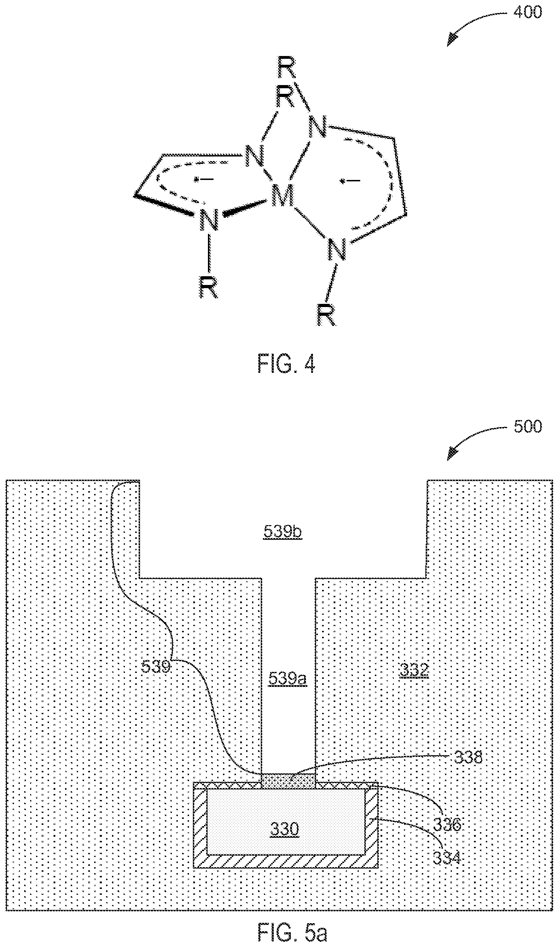

After a fabrication process of the semiconductor product embodied in the dies is complete, the wafer 11 may undergo a singulation process in which each of the dies (e.g., die 102) is separated from one another to provide discrete "chips" of the semiconductor product. The wafer 11 may be any of a variety of sizes. In some embodiments, the wafer 11 has a diameter ranging from about 25.4 mm to about 450 mm. The wafer 11 may include other sizes and/or other shapes in other embodiments. According to various embodiments, the interconnects 104 may be disposed on a semiconductor substrate in wafer form 10 or singulated form 100. The interconnects 104 described herein may be incorporated in a die 102 for logic or memory, or combinations thereof. In some embodiments, the interconnects 104 may be part of a system-on-chip (SoC) assembly. The interconnects 104 may include an interconnect assembly (e.g., interconnect assembly 300 or 500 of FIGS. 3a-b or FIGS. 5a-b) as described herein.

**FIG. 2** schematically illustrates a cross-section side view of an integrated circuit (IC) assembly 200, in accordance with some embodiments. In some embodiments, the IC assembly 200 may include one or more dies (hereinafter "die 102") electrically and/or physically coupled with a package substrate 121. In some embodiments, the package substrate 121 may be electrically coupled with a circuit board 122, as can be seen. In some embodiments, an integrated circuit (IC) device may include one or more of the die 102, package substrate 121 and/or circuit board 122, according to various embodiments. Embodiments described herein for providing a selective diffusion barrier may be implemented in any suitable IC device according to various embodiments.

The die 102 may represent a discrete product made from a semiconductor material (e.g., silicon) using semiconductor fabrication techniques such as thin film deposition, lithography, etching and the like used in connection with forming CMOS devices. In some embodiments, the die 102 may be, include, or be a part of a processor, memory, SoC or ASIC. In some embodiments, an electrically insulative material such as, for example, molding compound or underfill material (not shown) may encapsulate at least a portion of the die 102 and/or die-level interconnect structures 106.

The die 102 can be attached to the package substrate 121 according to a wide variety of suitable configurations including, for example, being directly coupled with the package substrate 121 in a flip-chip configuration, as depicted. In the flip-chip configuration, an active side, S1, of the die 102 including circuitry is attached to a surface of the package substrate 121 using die-level interconnect structures 106 such as bumps, pillars, or other suitable structures that may also electrically couple the die 102 with the package substrate 121. The active side S1 of the die 102 may include active devices such as, for example, transistor devices. An inactive side, S2, may be disposed opposite to the active side S1, as can be seen.

The die 102 may generally include a semiconductor substrate 102a, one or more device layers (hereinafter "device layer 102b") and one or more interconnect layers (hereinafter "interconnect layer 102c"). The semiconductor substrate 102a may be substantially composed of a bulk semiconductor material such as, for example silicon, in some embodiments. The device layer 102b may represent a region where active devices such as transistor devices are formed on the semiconductor substrate. The device layer 102b may include, for example, structures such as channel bodies and/or source/drain regions of transistor devices. The interconnect layer 102c may include interconnect structures (e.g., interconnects 104 of FIG. 1 or interconnect assembly 300, 500 of respective FIGS. 3a-b, FIGS. 5a-b) that are configured to route electrical signals to or from the active devices in the device layer 102b. For example, the interconnect layer 102c may include horizontal lines (e.g., trenches) and/or vertical plugs (e.g., vias) or other suitable features to provide electrical routing and/or contacts.

In some embodiments, the die-level interconnect structures 106 may be electrically coupled with the interconnect layer 102c and configured to route electrical signals between the die 102 and other electrical devices. The electrical signals may include, for example, input/output (I/O) signals and/or power/ground signals that are used in connection with operation of the die 102.

In some embodiments, the package substrate 121 is an epoxy-based laminate substrate having a core and/or build-up layers such as, for example, an Ajinomoto Build-up Film (ABF) substrate. The package substrate 121 may include other suitable types of substrates in other embodiments including, for example, substrates formed from glass, ceramic, or semiconductor materials.

The package substrate 121 may include electrical routing features configured to route electrical signals to or from the die 102. The electrical routing features may include, for example, pads or traces (not shown) disposed on one or more surfaces of the package substrate 121 and/or internal routing features (not shown) such as, for example, trenches, vias or other interconnect structures to route electrical signals through the package substrate 121. For example, in some embodiments, the package substrate 121 may include electrical routing features such as pads (not shown) configured to receive the respective die-level interconnect structures 106 of the die 102.

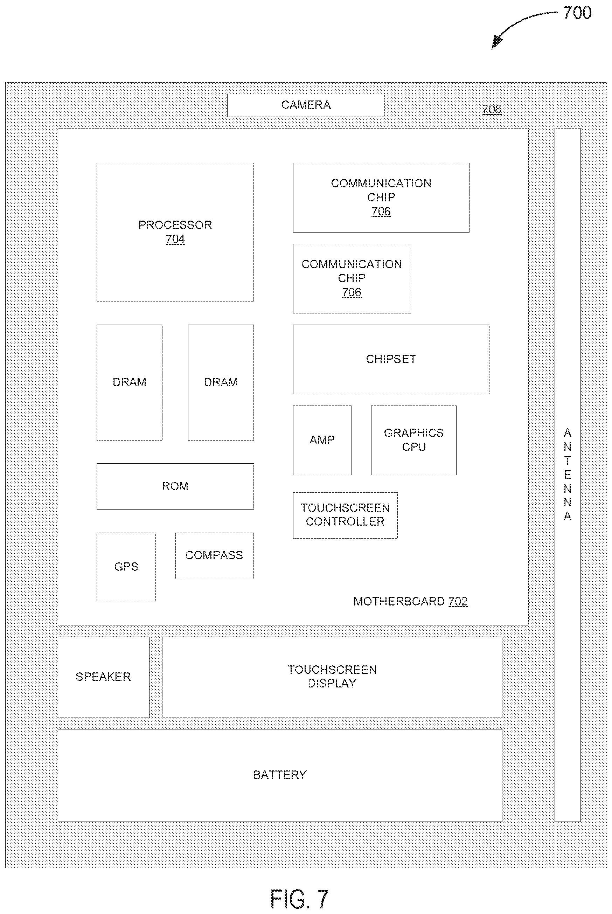

The circuit board 122 may be a printed circuit board (PCB) composed of an electrically insulative material such as an epoxy laminate. For example, the circuit board 122 may include electrically insulating layers composed of materials such as, for example, polytetrafluoroethylene, phenolic cotton paper materials such as Flame Retardant 4 (FR-4), FR-1, cotton paper and epoxy materials such as CEM-1 or CEM-3, or woven glass materials that are laminated together using an epoxy resin prepreg material. Interconnect structures (not shown) such as traces, trenches, or vias may be formed through the electrically insulating layers to route the electrical signals of the die 102 through the circuit board 122. The circuit board 122 may be composed of other suitable materials in other embodiments. In some embodiments, the circuit board 122 is a motherboard (e.g., motherboard 702 of FIG. 7).

Package-level interconnects such as, for example, solder balls 112 may be coupled to one or more pads (hereinafter "pads 110") on the package substrate 121 and/or on the circuit board 122 to form corresponding solder joints that are configured to further route the electrical signals between the package substrate 121 and the circuit board 122. The pads 110 may be composed of any suitable electrically conductive material such as metal including, for example, nickel (Ni), palladium (Pd), gold (Au), silver (Ag), copper (Cu), and combinations thereof. Other suitable techniques to physically and/or electrically couple the package substrate 121 with the circuit board 122 may be used in other embodiments.

The IC assembly 200 may include a wide variety of other suitable configurations in other embodiments including, for example, suitable combinations of flip-chip and/or wire-bonding configurations, interposers, multi-chip package configurations including system-in-package (SiP) and/or package-on-package (PoP) configurations. Other suitable techniques to route electrical signals between the die 102 and other components of the IC assembly 200 may be used in some embodiments.

**FIGS. 3a****-b** schematically illustrate a cross-section side view of an interconnect assembly 300 during various stages of fabrication, in accordance with some embodiments. Referring to **FIG. 3a****,** an interconnect assembly 300 is depicted subsequent to forming a first interconnect structure 330 in an electrically insulative material such as dielectric material 332 and forming a diffusion barrier 338 on the first interconnect structure 330.

In some embodiments, the dielectric material 332 may be deposited on a semiconductor substrate (e.g., semiconductor substrate 102a of FIG. 2). For example, the dielectric material 332 may be deposited as part of the formation of interconnect layers (e.g., interconnect layer 102c of FIG. 2) on a device layer (e.g., device layer 102b of Fig. 2). The dielectric material 332 may be composed of a variety of suitable materials including, for example, silicon oxide (SiO₂), high-k dielectric materials, low-k dielectric materials, carbon-doped silicon oxide, porous dielectric and like materials. In some embodiments, the dielectric material 332 may be deposited as a layer, which may be referred to as an interlayer dielectric (ILD) in some embodiments.

In some embodiments, the first interconnect structure 330 may be formed by forming an opening (e.g., trench) into the dielectric material 332 and forming a diffusion barrier 334 on surfaces of the trench (e.g., on the sidewalls and the bottom of trench). A metal may be deposited to substantially fill the trench and form the first interconnect structure 330. The diffusion barrier 334 may prevent or reduce diffusion of the metal of the first interconnect structure 330 into the dielectric material 332. For example, in some embodiments, the metal of the first interconnect structure 330 may be composed of copper and the diffusion barrier 334 may be composed of a copper diffusion barrier such as, for example, a metal nitride such as titanium nitride (TiN) and/or tantalum nitride (TaN). The first interconnect structure 330 and the diffusion barrier 334 may be composed of other suitable metals in other embodiments. In some embodiments, the interconnect assembly 300 may not include a diffusion barrier 334.

An etch stop film 336 is formed on the first interconnect structure 330. The etch stop film 336 may provide an etch stop for an etch process that may be used to form an opening 339 (e.g., via) for a second interconnect structure (e.g., second interconnect structure 340 of FIG. 3b). In some embodiments, the etch stop film 336 may be composed of a material with different etch selectivity than the dielectric material 332. For example, in some embodiments, the etch stop film 336 may be composed of silicon nitride (SiN) or like material. In some embodiments, the etch stop film 336 may be deposited on the first interconnect structure 330 subsequent to depositing the metal to form the first interconnect structure 330. Dielectric material 332 may be deposited on the etch stop film 336 and a patterning process (e.g., lithography and/or etch) may be performed to form the opening 339 through the deposited dielectric material 332 to expose the first interconnect structure 330. In some embodiments, the etch stop film 336 may further serve as a diffusion barrier between the metal of the first interconnect structure 330 and the dielectric material 332 deposited on the etch stop film 336. In some embodiments, the interconnect assembly 300 may not include an etch stop film 336.

In some embodiments, the opening 339 may be formed to expose metal on a top surface of the first interconnect structure 330. In some embodiments, sidewalls of the opening 339 may have a tapered profile owing to an etch process used to form the opening 339.

According to various embodiments, a diffusion barrier 338 may be selectively deposited on the metal of the first interconnect structure 330 to reduce or prevent diffusion between the metal of the first interconnect structure 330 and another different metal of a second interconnect structure (e.g., second interconnect structure 340 of FIG. 3b) to be formed in the opening 339. The diffusion barrier 338 may be formed by selectively depositing a metal (or metal compound) on the metal of the first interconnect structure 330 without directly depositing the metal of the diffusion barrier 338 on sidewalls of the opening 339. For example, referring to both FIG. 3a and FIG. 3b, metal of the diffusion barrier 338 may not be disposed on sidewalls of the opening 339 directly between the metal of the second interconnect structure 340 and the dielectric material 332 in some embodiments. The metal of the diffusion barrier 338 may be selectively deposited at an interface between metal of the first interconnect structure 330 and metal of the second interconnect structure 340, at the bottom of the opening 339, as can be seen. The diffusion barrier 338 ris coupled with (e.g., in direct contact with) material of the etch stop film 336. In some embodiments, the diffusion barrier 338 may have a thickness that is less than or equal to 20 nanometers (nm). In one embodiment, the diffusion barrier 338 may have a thickness that is less than or equal to 5 nm. The diffusion barrier 338 may have other suitable thicknesses in other embodiments.

In some embodiments, the diffusion barrier 338 may be deposited by atomic layer deposition (ALD) or chemical vapor deposition (CVD), with or without a co-reactant such as hydrogen (H₂) or ammonia (NH₃). In some embodiments, the deposition process may utilize a homoleptic N,N'-dialkyl-diazabutadiene metal precursor. **FIG. 4** schematically illustrates a metal precursor 400 for selective deposition of a diffusion barrier (e.g., diffusion barrier 338 of FIGS. 3a-b), in accordance with some embodiments. The metal precursor 400 may represent a general structure of a metal diazabutadiene ALD precursor where R may represent an alkyl group and M may represent a first row transition metal.

Referring again to FIGS. 3a-3b, in some embodiments, the diffusion barrier 338 may be deposited by electroless deposition. For example, Ni, Ni/B, Co/W, or Co-X or Ni-X where X represents one of tungsten (W), boron (B), phosphorous (P), nickel (Ni), rhenium-tin (ReSn), zinc (Zn), manganese (Mn), rhodium (Rh), ruthenium (Ru), chromium (Cr), platinum (Pt), osmium (Os), iridium (Ir) or other suitable materials may be selectively deposited by electroless deposition on the metal (e.g., Cu or Co) of the first interconnect structure 330, but not on the dielectric material 332 on the sidewalls in the opening 339. In some embodiments, a surface modification treatment may be applied to a surface of the metal of the first interconnect structure 330 to enhance or achieve selectivity of the deposition of the diffusion barrier 338. For example, a degree of ALD and/or CVD selectivity with precursors other than those containing diazabutadiene ligands has been demonstrated for Ru, MnN and Mn. In some embodiments, the surface modification treatment may include bis(dimethylamino)dimethylsilane, (N,N-dimethylamino)trimethylsilane, butyldimethy(dimethylamino)silane, and/or diN-butyldimethoxysilane, and like materials. In some embodiments, the selectively deposited metal of the diffusion barrier 338 may be infused or doped with one or more of boron (B), silicon (Si), germanium (Ge), tin (Sn), nitrogen (N), phosphorous (P), sulfur (S), selenium (Se) tellurium (Te), W, Ni, Re, Zn, Mn, Rh, Ru, Cr, Pt, Os, Ir or other suitable dopant to improve the barrier properties. For example, the diffusion barrier 338 may be doped with a dopant using diborane, silane, disilane, ammonia, hydrazine, phosphine, hydrogen sulfide, hydrogen selenide or diethyltelluride or other suitable gases during deposition of the diffusion barrier 338 or in a separate different temperature treatment prior to deposition. In one embodiment, Si may be added to a selectively deposited diffusion barrier 338 by soaking the diffusion barrier 338 in silane or disilane. Boron may be similarly added by soaking the diffusion barrier 338 in diborane. In some embodiments, the diffusion barrier 338 may be an amorphous material to provide better barrier properties for a given thickness relative to non-amorphous materials. The diffusion barrier 338 is formed by depositing multiple layers. The diffusion barrier 338 includes alternating layers of different metals such as Ni/W/Ni/W and the like. In some embodiments, the diffusion barrier 338 may be deposited as an ALD or CVD alloy.

Referring to **FIG. 3b****,** the interconnect assembly 300 is depicted subsequent to depositing a metal into the opening 339 of FIG. 3a to form a second interconnect structure 340 on the diffusion barrier 338. The metal of the second interconnect structure 340 may be deposited using any suitable process including, for example, CVD, ALD, physical vapor deposition (PVD) or electroless deposition.

The first interconnect structure 330 is composed of a metal or metal compound having a different chemical composition than a metal of the second interconnect structure 340. The diffusion barrier 338 has a different chemical composition than the second interconnect structure 340. In some embodiments, the diffusion barrier 338 may have a different chemical composition than the diffusion barrier 334 and/or the etch stop film 336. For example, in some embodiments, the first interconnect structure 330 may be composed of copper (Cu), the diffusion barrier 338 may be composed of a metal such as, for example, nickel (Ni), tungsten (W), molybdenum (Mo), iron (Fe), cobalt (Co), manganese (Mn) or zirconium (Zr), or a metal silicide or metal nitride where the metal may be one of the listed examples, and the second interconnect structure 340 may be composed of a metal such as, for example, cobalt (Co). In some embodiments, the diffusion barrier 338 may be composed of a mixture, compound, or alloy such as, for example, tungsten nitride (WN), nickel silicide (NiSi), Ni/Mn or Fe/Mn with appropriate selection of precursor, co-reactant and process. In some embodiments, the first interconnect structure 330 may be composed of Co and the second interconnect structure 340 may be composed of Cu. In other embodiments, the first interconnect structure 330 and/or the second interconnect structure 340 may be composed of a metal other than Cu or Co. For example, in some embodiments, the first interconnect structure 330 may be composed of Cu and the second interconnect structure 340 may be composed of a non-Cu metal other than Co such as, for example, Mo, W, Re, Fe, Ru, Os, Rh, Ir, Ni, Pd or Pt or a metal silicide such as, for example, nickel silicide or cobalt silicide. In one embodiment, copper germanide may be used to form one of the first interconnect structure 330 or second interconnect structure 340. To provide another example, in some embodiments, the first interconnect structure 330 may be composed of non-Cu metal such as, for example, Mo, W, Re, Fe, Ru, Os, Rh, Ir, Ni, Pd or Pt, or a metal silicide such as, for example, nickel silicide or cobalt silicide and the second interconnect structure 340 may be composed of Cu.

In some embodiments, the first interconnect structure 330 may be a trench structure and the second interconnect structure 340 may be a via structure. The via structure may have a critical dimension (CD) that is less than or equal to 60 nm in some embodiments. According to various embodiments, the interconnect assembly 300 may allow formation of a via structure (e.g., the second interconnect structure 340) using a non-Cu metal (e.g., Co) where no diffusion barrier is disposed between metal of the via structure and the dielectric material 332 (e.g., no diffusion barrier on sidewalls of opening 339). Techniques and configurations described in connection with interconnect assembly 300 may facilitate metallization of interconnect features, particularly the narrower via structure, at narrow critical dimension and high aspect ratio. Processes that fill the via structure (e.g., second interconnect structure 340 of FIG. 3b) separately from the trench structure (e.g., first interconnect structure 330 of FIG. 3b) may enable more via fill options. Forming a diffusion barrier (e.g., Cu diffusion barrier) on the sidewalls of the via structure may be undesirable because it may provide a smaller opening (e.g., opening 339 of FIG. 3a) resulting in more difficulty in filling the via structure. Additionally, forming a diffusion barrier on the sidewalls of the via structure may increase resistance through the via structure (e.g., TaN and TiN are more resistive than Co). Thus, eliminating a diffusion barrier around the metal of the second interconnect structure 340 may increase a cross-sectional area filled by the metal and reduce a height-to-width aspect ratio of the second interconnect structure 340 while increasing a resistance of the second interconnect structure 340. The selectively deposited diffusion barrier 338 may prevent intermixing of different metals of adjacent interconnect structures, which may reduce a number of voids, electrically open circuits and/or shorts as well as reduce leakage by limiting the movement of the two metals. The diffusion barrier 338 may further reduce device degradation that may occur when a metal such as Cu diffuses into the dielectric material 332 and then into the device layer of an IC device.

**FIGS. 5a****-b** schematically illustrate a cross-section side view of another interconnect assembly 500 during various stages of fabrication, in accordance with some embodiments. The interconnect assembly 500 may generally comport with embodiments described in connection with interconnect assembly 300 except the interconnect assembly 500 includes a dual-damascene structure 540 formed using a dual-damascene process.

Referring to **FIG. 5a****,** an interconnect assembly 500 is depicted subsequent to forming the diffusion barrier 334, first interconnect structure 330, etch stop film 336, opening 539 and/or diffusion barrier 338 according to techniques described in connection with FIG. 3a. The opening 539 may be configured to allow formation of a dual-damascene interconnect structure. That is, a via structure corresponding with a first opening 539a of the opening 539 and a trench structure corresponding with a second opening 539b of the opening 539 may be simultaneously filled during a same deposition process in some embodiments. In some embodiments, the second opening 539b may be formed in dielectric material 332 over the first interconnect structure 330 using patterning processes and the first opening 539a may be subsequently formed in the second opening 539b using patterning processes to expose the first interconnect structure 330. Subsequent to forming the first opening 539a, the diffusion barrier 338 may be formed on the first interconnect structure 330.

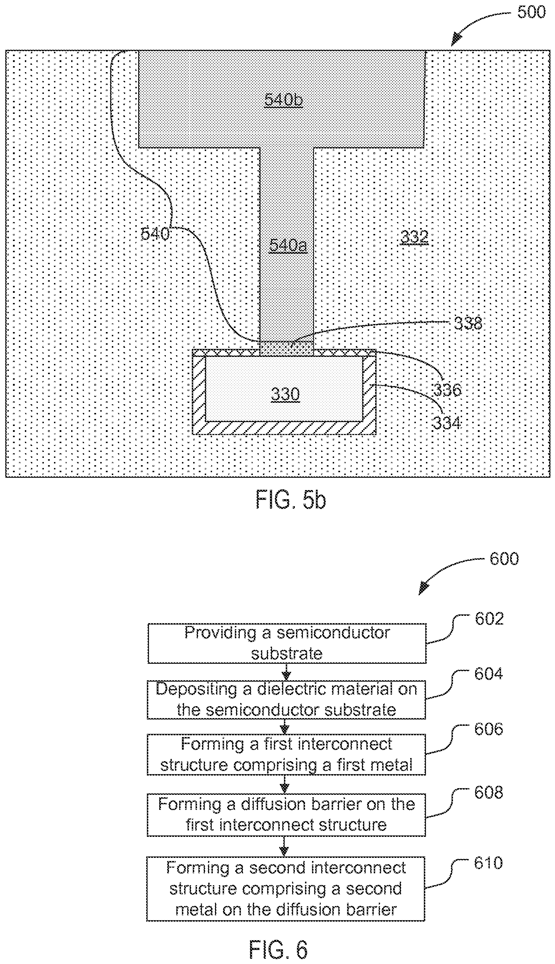

Referring to **FIG. 5b****,** the interconnect assembly 500 is depicted subsequent to depositing a metal to form a dual-damascene structure 540. In some embodiments, the metal may be deposited to simultaneously fill the first and second openings 539a, 539b to form respective second and third interconnect structures 540a, 540b. The second interconnect structure 540a may be a via structure and the third interconnect structure 540b may be a trench structure, in some embodiments. The metal of the dual-damascene structure 540 may comport with embodiments described in connection with metal for second interconnect structure 340 of FIG. 3.

**FIG. 6** schematically illustrates a flow diagram for a method 600 of fabricating an interconnect assembly (e.g., interconnect assembly 300 of FIGS. 3a-b or interconnect assembly 500 of FIGS. 5a-b), in accordance with some embodiments. The method 600 may comport with embodiments described in connection with FIGS. 1-5 and vice versa.

At 602, the method 600 may include providing a semiconductor substrate (e.g., semiconductor substrate 102a of FIG. 2). The semiconductor substrate may include a die in wafer form in some embodiments.

At 604, the method 600 may include depositing a dielectric material (e.g., dielectric material 332 of FIGS. 3a-b or FIGS. 5a-b) on the semiconductor substrate. For example, the dielectric material may be deposited to form an interconnect layer (e.g., interconnect layer 102c of FIG. 2) on a device layer (e.g., device layer 102b of FIG. 2) of a die.

At 606, the method 600 may include forming a first interconnect structure (e.g., first interconnect structure 330 of FIGS. 3a-b or FIGS. 5a-b) comprising a first metal. The first interconnect structure may be formed according to techniques described in connection with first interconnect structure 330 of FIGS. 3a-b. In some embodiments, forming the first interconnect structure may comprise forming an opening in the dielectric material and depositing the first metal into the opening. The first metal may comport with embodiments described in connection with metal of the first interconnect structure 330 of FIGS. 3a-b. In some embodiments, forming the first interconnect structure comprises forming a trench structure.

At 608, the method 600 may include forming a diffusion barrier (e.g., diffusion barrier 338 of FIGS. 3a-b or FIGS. 5a-b) on the first interconnect structure. In some embodiments, a third metal of the diffusion barrier may be selectively deposited on the first metal of the first interconnect structure. For example, the third metal may be deposited at an interface between the first interconnect structure and a second interconnect structure to be formed on the diffusion barrier. The selective deposition may deposit the third metal on the first metal without depositing on the dielectric material 332 such that the third metal of the diffusion barrier is not disposed directly between a second metal of the second interconnect structure and the dielectric material (e.g., the third metal is not disposed on the sidewalls of opening 339 of FIG. 3a) after depositing the second metal on the diffusion barrier.

The third metal of the diffusion barrier may comport with embodiments described in connection with the metal of the diffusion barrier 338 of FIGS. 3a-b. In some embodiments, the third metal may be deposited by ALD or CVD. In some embodiments, forming the diffusion barrier comprises doping the third metal with one or more of boron (B), silicon (Si), germanium (Ge), tin (Sn), nitrogen (N), phosphorous (P), sulfur (S), selenium (Se) or tellurium (Te). In some embodiments, selectively depositing the third metal may include using a homoleptic N,N' -dialkyl-diazabutadiene metal precursor. In some embodiments, forming the diffusion barrier may comprise forming multiple layers.

At 610, the method 600 may include forming a second interconnect structure (e.g., second interconnect structure 340 of FIGS. 3a-b or dual-damascene structure 540 of FIGS. 5a-b) comprising a second metal on the diffusion barrier. In some embodiments, the first metal and the second metal may have a different chemical composition. Material of the diffusion barrier (e.g., diffusion barrier 338 of FIGS. 3a-b or FIGS. 5a-b) and the second metal may have a different chemical composition. In some embodiments, the second interconnect structure is a via structure. In other embodiments, the second interconnect structure may be a dual-damascene structure.

Various operations are described as multiple discrete operations in turn, in a manner that is most helpful in understanding the claimed subject matter. However, the order of description should not be construed as to imply that these operations are necessarily order dependent. Embodiments of the present disclosure may be implemented into a system using any suitable hardware and/or software to configure as desired.

**FIG. 7** schematically illustrates an example system (e.g., computing device 700) that may include an interconnect assembly (e.g., interconnect assembly 300 of FIGS. 3a-b or interconnect assembly 500 of FIGS. 5a-b) as described herein, in accordance with some embodiments. Components of the computing device 700 may be housed in an enclosure (e.g., housing 708). The motherboard 702 may include a number of components, including but not limited to a processor 704 and at least one communication chip 706. The processor 704 may be physically and electrically coupled to the motherboard 702. In some implementations, the at least one communication chip 706 may also be physically and electrically coupled to the motherboard 702. In further implementations, the communication chip 706 may be part of the processor 704.

Depending on its applications, computing device 700 may include other components that may or may not be physically and electrically coupled to the motherboard 702. These other components may include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, a Geiger counter, an accelerometer, a gyroscope, a speaker, a camera, and a mass storage device (such as hard disk drive, compact disk (CD), digital versatile disk (DVD), and so forth).

The communication chip 706 may enable wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible broadband wireless access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 706 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 706 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 706 may operate in accordance with Code Division Multiple Access (CDMA), Time Division Multiple Access (TDMA), Digital Enhanced Cordless Telecommunications (DECT), Evolution-Data Optimized (EV-DO), derivatives thereof, as well as any other wireless protocols that are designated as 3G, 4G, 5G, and beyond. The communication chip 706 may operate in accordance with other wireless protocols in other embodiments.

The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, EV-DO, and others.

The processor 704 of the computing device 700 may include a die (e.g., die 102 of FIGS. 1-2) having an interconnect assembly (e.g., interconnect assembly 300 of FIGS. 3a-b or interconnect assembly 500 of FIGS. 5a-b) as described herein. For example, the die 102 of FIGS. 1-2 may be mounted in a package assembly that is mounted on a circuit board such as the motherboard 702. The term "processor" may refer to any device or portion of a device that processes electronic data from registers and/or memory to transform that electronic data into other electronic data that may be stored in registers and/or memory.

The communication chip 706 may also include a die (e.g., die 102 of FIGS. 1-2) having an interconnect assembly (e.g., interconnect assembly 300 of FIGS. 3a-b or interconnect assembly 500 of FIGS. 5a-b) as described herein. In further implementations, another component (e.g., memory device or other integrated circuit device) housed within the computing device 700 may contain a die (e.g., die 102 of FIGS. 1-2) having an interconnect assembly (e.g., interconnect assembly 300 of FIGS. 3a-b or interconnect assembly 500 of FIGS. 5a-b) as described herein.

In various implementations, the computing device 700 may be a mobile computing device, a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

The above description of illustrated implementations, including what is described in the Abstract, is not intended to be exhaustive or to limit the embodiments of the present disclosure to the precise forms disclosed. While specific implementations and examples are described herein for illustrative purposes, various equivalent modifications are possible within the scope of the present disclosure, as those skilled in the relevant art will recognize.

These modifications may be made to embodiments of the present disclosure in light of the above detailed description. The terms used in the following claims should not be construed to limit various embodiments of the present disclosure to the specific implementations disclosed in the specification and the claims. However the scope is to be determined entirely by the following

## Claims

1. An apparatus comprising:
a dielectric material (332);
a first interconnect structure (330) comprising a first metal disposed in the dielectric material (332);
a second interconnect structure (340, 540a) comprising a second metal disposed in the dielectric material (332) and electrically coupled with the first interconnect structure (330);
a diffusion barrier (338) disposed at an interface between the first interconnect structure (330) and the second interconnect structure (340, 540a), wherein the first metal and the second metal have a different chemical composition, material of the diffusion barrier (338) and the second metal have a different chemical composition and material of the diffusion barrier (338) is not disposed directly between the second metal and the dielectric material (332); and further **characterised by** comprising
an etch stop film (336) disposed on the first interconnect structure (330) and
coupled with the diffusion barrier (338), wherein
the diffusion barrier (338) includes alternating layers of different metals.

2. The apparatus of claim 1, wherein:
the first metal comprises copper (Cu); and
the second metal comprises cobalt (Co).

3. The apparatus of claim 1, wherein the diffusion barrier (338) comprises a metal, metal silicide or metal nitride.

4. The apparatus of claim 3, wherein the diffusion barrier (338) comprises nickel (Ni), tungsten (W), molybdenum (Mo), iron (Fe), cobalt (Co), manganese (Mn) or zirconium (Zr).

5. The apparatus of any of claims 1-4, wherein:
the first interconnect structure (330) comprises a trench structure; and
the second interconnect structure (340, 540a) comprises a via structure or dual-damascene structure (540).

6. The apparatus of any of claims 1-4, further comprising:
an additional diffusion barrier (334) disposed between the first metal and the dielectric material (332), wherein material of the additional diffusion barrier (334) has a different chemical composition than the material of the diffusion barrier (338).

7. The apparatus of any of claims 1-4, wherein the diffusion barrier (338) comprises a metal doped with one or more of boron (B), silicon (Si), germanium (Ge), tin (Sn), nitrogen (N), phosphorous (P), sulfur (S), selenium (Se), tellurium (Te), tungsten (W), nickel (Ni), rhenium (Re), tin (Sn), zinc (Zn), manganese (Mn), rhodium (Rh), ruthenium (Ru), chromium (Cr), platinum (Pt), osmium (Os), or iridium (Ir).

8. A method comprising:
forming a first interconnect structure (330) comprising a first metal;
forming a diffusion barrier (338) on the first interconnect structure (330);
forming a second interconnect structure (340, 540a) comprising a second metal on the diffusion barrier (338), wherein the diffusion barrier (338) is disposed at an interface between the first interconnect structure (330) and the second interconnect structure (340, 540a), the first metal and the second metal have a different chemical composition, material of the diffusion barrier (338) and the second metal have a different chemical composition, the first interconnect structure (330) and the second interconnect structure (340, 540a) are disposed in a dielectric material (332), and material of the diffusion barrier (338) is not disposed directly between the second metal and the dielectric material (332); and
forming an etch stop film (336) on the first interconnect structure (330) prior to forming the diffusion barrier (338), wherein subsequent to forming the diffusion barrier (338), the etch stop film is coupled with the diffusion barrier (338), wherein forming the diffusion barrier comprises forming alternating layers of different metals.

9. The method of claim 8, wherein:
forming the first interconnect structure (330) comprises depositing the first metal;
forming the second interconnect structure (340, 540a) comprises depositing the second metal;
the first metal comprises copper (Cu); and
the second metal comprises cobalt (Co).

10. The method of claim 8. wherein forming the diffusion barrier (338) comprises selectively depositing a third metal on the first metal of the first interconnect structure (330).

11. The method of claim 10., wherein forming the diffusion barrier (338) comprises selectively depositing nickel (Ni), tungsten (W), molybdenum (Mo), iron (Fe), cobalt (Co), or manganese (Mn).

12. The method of claim 10., wherein forming the diffusion barrier (338) comprises doping the third metal with one or more of boron (B), silicon (Si), germanium (Ge), tin (Sn), nitrogen (N), phosphorous (P), sulfur (S), selenium (Se), tellurium (Te), tungsten (W), nickel (Ni), rhenium (Re), tin (Sn), zinc (Zn), manganese (Mn), rhodium (Rh), ruthenium (Ru), chromium (Cr), platinum (Pt), osmium (Os), or iridium (Ir).

13. The method of claim 10, wherein selectively depositing the third metal is performed by atomic layer deposition (ALD) or chemical vapor deposition (CVD).

## Patentansprüche

1. Vorrichtung, Folgendes umfassend:
ein dielektrisches Material (332);
eine erste Verbindungswegestruktur (330), die ein erstes Metall umfasst, das in dem dielektrischen Material (332) angeordnet ist;
eine zweite Verbindungswegestruktur (340, 540a), die ein zweites Metall umfasst, das in dem dielektrischen Material (332) angeordnet ist, und die mit der ersten Verbindungswegestruktur (330) elektrisch verbunden ist;
eine Diffusionssperre (338), die an einer Grenzfläche zwischen der ersten Verbindungswegestruktur (330) und der zweiten Verbindungswegestruktur (340, 540a) angeordnet ist, wobei das erste Metall und das zweite Metall eine verschiedene chemische Zusammensetzung aufweisen, das Material der Diffusionssperre (338) und das zweite Metall eine verschiedene chemische Zusammensetzung aufweisen und das Material der Diffusionssperre (338) nicht unmittelbar zwischen dem zweiten Metall und dem dielektrischen Material (332) angeordnet ist; und weiterhin **dadurch gekennzeichnet, dass** sie Folgendes umfasst
einen Ätzstoppfilm (336), der auf der ersten Verbindungswegestruktur (330) angeordnet ist und mit der Diffusionssperre (338) verbunden ist, wobei
die Diffusionssperre (338) alternierende Schichten verschiedener Metalle umfasst.

2. Vorrichtung nach Anspruch 1, wobei:
das erste Metall Kupfer (Cu) umfasst; und
das zweite Metall Kobalt (Co) umfasst.

3. Vorrichtung nach Anspruch 1, wobei die Diffusionssperre (338) ein Metall, ein Metallsilizid oder ein Metallnitrid umfasst.

4. Vorrichtung nach Anspruch 3, wobei die Diffusionssperre (338) Nickel (Ni), Wolfram (W), Molybdän (Mo), Eisen (Fe), Kobalt (Co), Mangan (Mn) oder Zirkonium (Zr) umfasst.

5. Vorrichtung nach einem der Ansprüche 1 bis 4, wobei:
die erste Verbindungswegestruktur (330) eine Grabenstruktur umfasst; und
die zweite Verbindungswegestruktur (340, 540a) eine Durchkontaktstruktur oder eine duale Damaszierstruktur (540) umfasst.

6. Vorrichtung nach einem der Ansprüche 1 bis 4, weiterhin Folgendes umfassend:
eine zusätzliche Diffusionssperre (334), die zwischen dem ersten Metall und dem dielektrischen Material (332) angeordnet ist, wobei ein Material der zusätzlichen Diffusionssperre (334) eine chemische Zusammensetzung aufweist, die von dem Material der Diffusionssperre (338) verschieden ist.

7. Vorrichtung nach einem der Ansprüche 1 bis 4, wobei die Diffusionssperre (338) ein Metall umfasst, das mit einem oder mehreren Stoffen der Gruppe dotiert ist, bestehend aus Bor (B), Silizium (Si), Germanium (Ge), Zinn (Sn), Stickstoff (N), Phosphor (P), Schwefel (S), Selen (Se), Tellur (Te), Wolfram (W), Nickel (Ni), Rhenium (Re), Zinn (Sn), Zink (Zn), Mangan (Mn), Rhodium (Rh), Ruthenium (Ru), Chrom (Cr), Platin (Pt), Osmium (Os) oder Iridium (Ir).

8. Verfahren, Folgendes umfassend:
Ausbilden einer ersten Verbindungswegestruktur (330), die ein erstes Metall umfasst;
Ausbilden einer Diffusionssperre (338) auf der ersten Verbindungswegestruktur (330);
Ausbilden einer zweiten Verbindungswegestruktur (340, 540a), die ein zweites Metall umfasst, auf der Diffusionssperre (338), wobei die Diffusionssperre (338) an einer Grenzfläche zwischen der ersten Verbindungswegestruktur (330) und der zweiten Verbindungswegestruktur (340, 540a) angeordnet ist, das erste Metall und das zweite Metall eine verschiedene chemische Zusammensetzung aufweisen, ein Material der Diffusionssperre (338) und das zweite Metall eine verschiedene chemische Zusammensetzung aufweisen, die erste Verbindungswegestruktur (330) und die zweite Verbindungswegestruktur (340, 540a) in einem dielektrischen Material (332) angeordnet sind und ein Material der Diffusionssperre (338) nicht unmittelbar zwischen dem zweiten Metall und dem dielektrischen Material (332) angeordnet ist; und
Ausbilden eines Ätzstoppfilms (336) auf der ersten Verbindungswegestruktur (330) vor dem Ausbilden der Diffusionssperre (338), wobei der Ätzstoppfilm einem Ausbilden der Diffusionssperre (338) nachfolgend mit der Diffusionssperre (338) verbunden wird,
wobei Ausbilden der Diffusionssperre Ausbilden alternierender Schichten verschiedener Metalle umfasst.

9. Verfahren nach Anspruch 8, wobei:
Ausbilden der ersten Verbindungswegestruktur (330) Ablagern des ersten Metalls umfasst;
Ausbilden der zweiten Verbindungswegestruktur (340, 540a) Ablagern des zweiten Metalls umfasst;
das erste Metall Kupfer (Cu) umfasst; und
das zweite Metall Kobalt (Co) umfasst.

10. Verfahren nach Anspruch 8,
wobei Ausbilden der Diffusionssperre (338) selektives Ablagern eines dritten Metalls auf dem ersten Metall der ersten Verbindungswegestruktur (330) umfasst.

11. Verfahren nach Anspruch 10,
wobei Ausbilden der Diffusionssperre (338) selektives Ablagern von Nickel (Ni), Wolfram (W), Molybdän (Mo), Eisen (Fe), Kobalt (Co) oder Mangan (Mn) umfasst.

12. Verfahren nach Anspruch 10,
wobei Ausbilden der Diffusionssperre (338) Folgendes umfasst
Dotieren des dritten Metalls mit einem oder mehreren Stoffen der Gruppe, bestehend aus Bor (B), Silizium (Si), Germanium (Ge), Zinn (Sn), Stickstoff (N), Phosphor (P), Schwefel (S), Selen (Se), Tellur (Te), Wolfram (W), Nickel (Ni), Rhenium (Re), Zinn (Sn), Zink (Zn), Mangan (Mn), Rhodium (Rh), Ruthenium (Ru), Chrom (Cr), Platin (Pt), Osmium (Os) oder Iridium (Ir).

13. Verfahren nach Anspruch 10,
wobei selektives Ablagern des dritten Metalls durch Atomlagenablagerung (ALD) oder chemische Dampfabscheidung (CVD) durchgeführt wird.

## Revendications

1. Appareil comprenant :
un matériau diélectrique (332) ;
une première structure d'interconnexion (330) comprenant un premier métal disposée dans le matériau diélectrique (332) ;
une deuxième structure d'interconnexion (340, 540a) comprenant un deuxième métal disposée dans le matériau diélectrique (332) et couplée électriquement à la première structure d'interconnexion (330) ;
une barrière à la diffusion (338) disposée à une interface entre la première structure d'interconnexion (330) et la deuxième structure d'interconnexion (340, 540a), le premier métal et le deuxième métal ayant une composition chimique différente, le matériau de la barrière à la diffusion (338) et le deuxième métal ayant une composition chimique différente, et le matériau de la barrière à la diffusion (338) n'étant pas disposé directement entre le deuxième métal et le matériau diélectrique (332) ; et **caractérisé en outre en ce qu'**il comprend
un film d'arrêt de gravure (336) disposé sur la première structure d'interconnexion (330) et couplé à la barrière à la diffusion (338), dans lequel
la barrière à la diffusion (338) comporte des couches alternées de différents métaux.

2. Appareil de la revendication 1, dans lequel :
le premier métal comprend du cuivre (Cu) ; et
le deuxième métal comprend du cobalt (Co).

3. Appareil de la revendication 1, dans lequel la barrière à la diffusion (338) comprend un métal, un siliciure métallique ou un nitrure métallique.

4. Appareil de la revendication 3, dans lequel la barrière à la diffusion (338) comprend du nickel (Ni), du tungstène (W), du molybdène (Mo), du fer (Fe), du cobalt (Co), du manganèse (Mn) ou du zirconium (Zr).

5. Appareil de l'une quelconque des revendications 1 à 4, dans lequel :
la première structure d'interconnexion (330) comprend une structure de tranchée ; et
la deuxième structure d'interconnexion (340, 540a) comprend une structure de trou d'interconnexion ou une structure à double damascène (540).

6. Appareil de l'une quelconque des revendications 1 à 4, comprenant en outre :
une barrière à la diffusion supplémentaire (334) disposée entre le premier métal et le matériau diélectrique (332), le matériau de la barrière à la diffusion supplémentaire (334) ayant une composition chimique différente de celle du matériau de la barrière à la diffusion (338).

7. Appareil de l'une quelconque des revendications 1 à 4, dans lequel la barrière à la diffusion (338) comprend un métal dopé avec un ou plusieurs éléments parmi le bore (B), le silicium (Si), le germanium (Ge), l'étain (Sn), l'azote (N), le phosphore (P), le soufre (S), le sélénium (Se), le tellure (Te), le tungstène (W), le nickel (Ni), le rhénium (Re), l'étain (Sn), le zinc (Zn), le manganèse (Mn), le rhodium (Rh), le ruthénium (Ru), le chrome (Cr), le platine (Pt), l'osmium (Os), et l'iridium (Ir).

8. Procédé comprenant :
la formation d'une première structure d'interconnexion (330) comprenant un premier métal ;
la formation d'une barrière à la diffusion (338) sur la première structure d'interconnexion (330) ;
la formation d'une deuxième structure d'interconnexion (340, 540a) comprenant un deuxième métal sur la barrière à la diffusion (338), la barrière à la diffusion (338) étant disposée à une interface entre la première structure d'interconnexion (330) et la deuxième structure d'interconnexion (340, 540a), le premier métal et le deuxième métal ayant une composition chimique différente, le matériau de la barrière à la diffusion (338) et le deuxième métal ayant une composition chimique différente, la première structure d'interconnexion (330) et la deuxième structure d'interconnexion (340, 540a) étant disposées dans un matériau diélectrique (332), et le matériau de la barrière à la diffusion (338) n'étant pas disposé directement entre le deuxième métal et le matériau diélectrique (332) ; et
la formation d'un film d'arrêt de gravure (336) sur la première structure d'interconnexion (330) avant la formation de la barrière à la diffusion (338), dans lequel, après la formation de la barrière à la diffusion (338), le film d'arrêt de gravure est couplé à la barrière à la diffusion (338), la formation de la barrière à la diffusion comprenant la formation de couches alternées de différents métaux.

9. Procédé de la revendication 8, dans lequel :
la formation de la première structure d'interconnexion (330) comprend le dépôt du premier métal ;
la formation de la deuxième structure d'interconnexion (340, 540a) comprend le dépôt du deuxième métal ;
le premier métal comprend du cuivre (Cu) ; et
le deuxième métal comprend du cobalt (Co).

10. Procédé de la revendication 8,
dans lequel la formation de la barrière à la diffusion (338) comprend le dépôt sélectif d'un troisième métal sur le premier métal de la première structure d'interconnexion (330).

11. Procédé de la revendication 10,
dans lequel la formation de la barrière à la diffusion (338) comprend le dépôt sélectif de nickel (Ni), tungstène (W), molybdène (Mo), fer (Fe), cobalt (Co), ou manganèse (Mn).

12. Procédé de la revendication 10,
dans lequel la formation de la barrière à la diffusion (338) comprend le dopage du troisième métal avec un plusieurs éléments parmi le bore (B), le silicium (Si), le germanium (Ge), l'étain (Sn), l'azote (N), le phosphore (P), le soufre (S), le sélénium (Se), le tellure (Te), le tungstène (W), le nickel (Ni), le rhénium (Re), l'étain (Sn), le zinc (Zn), le manganèse (Mn), le rhodium (Rh), le ruthénium (Ru), le chrome (Cr), le platine (Pt), l'osmium (Os), et l'iridium (Ir).

13. Procédé de la revendication 10,
dans lequel le dépôt sélectif du troisième métal est effectué par dépôt de couches atomiques (ALD) ou dépôt chimique en phase vapeur (CVD).
